Europäisches Patentamt

European Patent Office

Office européen des brevets

(11) Numéro de publication: **0 146 427**
A2

# (12) DEMANDE DE BREVET EUROPEEN

(21) Numéro de dépôt: **84402180.8**

(22) Date de dépôt: **30.10.84**

(51) Int. Cl.⁴: **H 01 L 21/76, H 01 L 21/32**

(30) Priorité: **04.11.83 FR 8317584**

(43) Date de publication de la demande: **26.06.85 Bulletin 85/26**

(84) Etats contractants désignés: **DE GB IT NL**

(71) Demandeur: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Gris, Yvon, THOMSON-CSF SCPI 173, bld Haussmann, F-75379 Paris Cedex 08 (FR)**
Inventeur: **Monroy-Aguirre, Agustin, THOMSON-CSF SCPI 173, bld Haussmann, FR-75379 Paris Cedex 08 (FR)**

(74) Mandataire: **Guérin, Michel et al, THOMSON-CSF SCPI 173, Bld Haussmann, F-75379 Paris Cédex 08 (FR)**

(54) **Procédé de fabrication de structures intégrées de silicium sur îlots isolés du substrat.**

(57) L'invention concerne un procédé de fabrication de circuits intégrés dans lequel on réalise des îlots de silicium monocristallin (22) complètement isolés du substrat (10) lui-même en silicium monocristallin, par une couche d'oxyde épais (20).

On forme cette couche d'oxyde épais de la manière suivante: on forme des îlots de silicium dont le dessus et les flancs sont protégés avec du nitrure de silicium. On attaque alors le silicium isotropiquement, ce qui creuse profondément sous les îlots. Une oxydation épaisse comble alors la totalité du silicium sous l'îlot.

On aboutit ainsi à des îlots de silicium isolés et de même qualité cristalline que le substrat.

## PROCEDE DE FABRICATION DE STRUCTURES INTEGREES DE SILICIUM
## SUR ILOTS ISOLES DU SUBSTRAT

La présente invention concerne les structures de circuit intégré incorporant des zones de semiconducteur monocristallin isolées diélectriquement du substrat qui les supporte.

Ces structures se différencient des structures classiques où les éléments de circuit intégré sont formés directement dans le volume du substrat semiconducteur et ne sont isolés les uns des autres que par des jonctions polarisées en inverse. Elles sont utilisées lorsqu'on a besoin d'une isolation plus efficace qu'une isolation par jonction.

Les procédés utilisés pour réaliser une isolation par diélectrique sont chers et difficiles à mettre en oeuvre.

Parmi eux, on peut citer l'utilisation de substrats complètement isolants tels que du corindon au lieu d'un substrat de semiconducteur ; on fait croître du silicium monocristallin sur le substrat et on grave le silicium pour ne laisser subsister que des îlots séparés qui sont isolés diélectriquement les uns des autres puisqu'ils reposent sur le substrat isolant. Cette technique est délicate car le corindon est un matériau fragile, lourd et difficile à travailler, supportant mal les chocs thermiques. De plus, la qualité cristalline du silicium déposé sur le corindon n'est pas très bonne.

On peut citer aussi des techniques de mise en oeuvre complexes et chères, dans lesquelles, par différents dépôts et retournement de tranches de silicium, on finit par créer des îlots de silicium complètement isolés (technique EPIC).

La recristallisation de silicium amorphe déposé sur un substrat de silicium recouvert d'oxyde isolant est aussi une technique de formation d'îlots isolés diélectriquement du substrat, mais la qualité cristalline de ces îlots obtenus par recristallisation de silicium amorphe est relativement mauvaise (présence de grains en bordure de zone recristallisée).

La présente invention propose un nouveau procédé de for-

2

mation d'îlots isolés diélectriquement par rapport au substrat qui les supporte, ce procédé ayant l'avantage d'être particulièrement simple, peu coûteux, permettant l'utilisation d'un substrat de silicium monocristallin, et offrant une bonne qualité cristalline des îlots du fait que les îlots sont formés à partir du substrat monocristallin lui-même. De plus, ce procédé est parfaitement compatible avec les procédés de fabrication classiques où les éléments de circuit sont isolés par jonction et non par diélectrique, de sorte qu'on pourra trouver dans le même circuit des éléments isolés par jonction (formés dans le volume du substrat) et des éléments isolés diélectriquement (formés sur des îlots isolés diélectriquement du substrat).

Le procédé selon l'invention comprend les étapes suivantes :

a) on part d'une tranche de silicium monocristallin que l'on recouvre, éventuellement après une oxydation mince, d'une première couche de nitrure de silicium,

b) on grave le nitrure selon un motif laissant subsister des zones de faible largeur,

c) on creuse verticalement le silicium monocristallin, en dehors des endroits protégés par le nitrure, de sorte qu'il subsiste des îlots de silicium monocristallin dont la surface supérieure est recouverte de nitrure,

d) on dépose une deuxième couche de nitrure de silicium qui recouvre la surface de la tranche ainsi que les flancs de l'îlot et la première couche de nitrure,

e) on effectue une gravure anisotrope verticale du nitrure jusqu'à mise à nu du silicium en dehors des îlots, le nitrure de la deuxième couche subsistant alors sur les flancs des îlots et celui de la première couche subsistant sur le dessus des îlots,

f) on effectue une gravure isotrope du silicium dénudé, en dehors des îlots protégés par le nitrure, cette gravure s'étendant partiellement sous les îlots.

g) on effectue une oxydation thermique épaisse de la tranche pendant une durée suffisante pour que se forme une couche

3

d'oxyde de silicium s'étendant complètement sous les flots et isolant diélectriquement ceux-ci du substrat,

       h) on retire la couche de nitrure subsistant sur les flots.

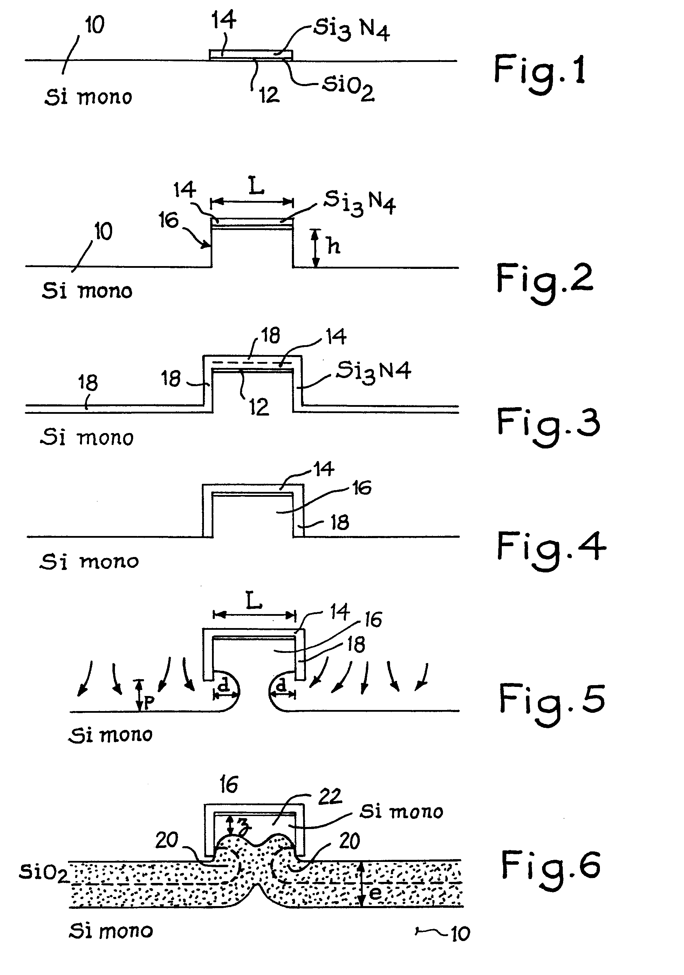

       D'autres caractéristiques et avantages de l'invention apparaîtront à la lecture de la description détaillée qui suit et qui est faite en référence aux dessins annexés dans lesquels les figures 1 à 6 représentent les étapes successives du procédé de fabrication selon l'invention.

       On part d'un substrat 10 qui est une tranche de silicium monocristallin, que l'on recouvre uniformément, après formation d'une couche mince d'oxyde de silicium 12 (environ 500 angströms), d'une couche de nitrure de silicium 14. L'oxyde est simplement destiné à empêcher que la couche de nitrure ne dégrade la qualité cristalline de la surface de silicium qu'elle recouvre.

       Les couches 14 et 12 sont gravées selon un motif laissant subsister des flots de faible largeur à l'endroit où l'on voudra des flots de silicium monocristallin isolés diélectriquement du substrat. Cette gravure du nitrure se fait classiquement après dépôt d'une couche de résine, exposition à travers un masque approprié, développement de la résine, et attaque chimique du nitrure là où il n'est pas protégé par la résine. Le résultat est représenté à la figure 1.

       En utilisant le nitrure subsistant comme masque de gravure, on attaque le silicium monocristallin là où il n'est pas recouvert de nitrure, selon un procédé de gravure anisotrope verticale (par plasma de $CCl_4$ par exemple ou par gravure ionique réactive), sur une épaisseur h d'environ 0,5 micron.

       Il subsiste alors des flots 16 de silicium monocristallin à flancs sensiblement verticaux, faisant saillie au dessus de la surface de la tranche, ces flots ayant une faible largeur L et étant recouverts d'une couche de nitrure de silicium 14 (fig 2).

       On dépose alors une deuxième couche 18 de nitrure, uniformément, de manière à recouvrir non seulement la surface de la tranche, mais aussi les flancs verticaux et la surface supérieure des flots ; cette dernière est déjà recouverte de

4

nitrure, de sorte qu'elle présente en fin de dépôt, une épaisseur de nitrure supérieure à celle qui existe sur le reste de la surface de la tranche (fig 3).

On effectue ensuite une attaque anisotrope, sensiblement verticalement, du nitrure de silicium, par gravure ionique réactive ou par gravure avec un plasma anisotrope (par exemple plasma de $SF_6$, anisotrope pour le nitrure). On arrête la gravure lorsqu'on a éliminé une épaisseur verticale de nitrure égale à l'épaisseur de la deuxième couche, c'est à dire en pratique lorsque le silicium apparaît à nu en dehors des îlots 16. L'arrêt de la gravure peut se faire notamment en détectant, par un moyen optique ou physique (détection de changement de pression) le début de l'attaque du silicium mis à nu. Il subsiste alors sur la tranche des îlots 16 de silicium monocristallin recouverts sur leurs flancs de nitrure de silicium (en principe sans interposition d'oxyde de silicium) et recouverts sur le dessus d'oxyde mince et de nitrure de silicium (fig 4).

On effectue alors une gravure isotrope du silicium là où il n'est pas protégé par le nitrure, par exemple au moyen d'un plasma de $SF_6$ (isotrope pour l'attaque du silicium) ou par un bain chimique. La durée et les conditions d'attaque sont choisies telles que le silicium soit creusé sur une profondeur p à peu près égale au quart de la largeur L des îlots, par exemple 0,25 micron pour un îlot de 1 micron de large. On choisira, pour les îlots qui doivent être isolés diélectriquement, une largeur L faible de l'ordre de 1 micron pour qu'il ne soit pas nécessaire de creuser trop profondément le silicium. Il résulte de l'isotropie de l'attaque du silicium que le silicium se creuse partiellement sous les îlots sur une distance latérale d à peu près égale à la profondeur p de gravure verticale du silicium, les bords de l'îlot restant en surplomb sur cette distance d (fig 5).

On effectue enfin une oxydation thermique épaisse du silicium, de manière que le silicium soit oxydé sur toute sa surface mise à nu, y compris sous les bords en surplomb des îlots, sur une épaisseur telle que les couches d'oxydes 20 créées de chaque côté de la largeur L de l'îlot se rejoignent au centre de

l'îlot ; une zone 22 de silicium monocristallin, constituant la partie supérieure de l'îlot 16, est ainsi isolée complètement par l'oxyde épais 20 (fig 6).

Comme on le sait, une oxydation thermique "consomme" une parie d'épaisseur de silicium, (environ la moitié de l'épaisseur finale d'oxyde), c'est à dire qu'en pratique, pour combler l'épaisseur L-2d de silicium monocristallin constituant le pied de l'îlot à la figure 5, il faut faire croître une épaisseur e d'oxyde environ égale à L-2d sur toute la surface de la tranche. Sur la figure 6 on a représenté en traits pointillés la surface initialement à nu du silicium pour montrer que l'oxyde croît à peu près autant à l'extérieur qu'à l'intérieur de cette surface.

Bien entendu, pour que la zone 22 de silicium monocristallin soit utilisable, il faut qu'elle ait une hauteur z minimale et qu'elle ne soit pas complètement envahie par la remontée de l'oxyde épais. Ceci suppose donc qu'on est parti d'une hauteur h d'îlot initial de silicium (fig 2) suffisamment élevée par rapport à la largeur L de l'îlot, par exemple d'une hauteur h égale à z + L-2d où z est la hauteur minimale de silicium monocristallin que l'on veut conserver.

A titre d'exemple, la hauteur z peut être égale à 0,5 micron, et, si d = 0,25 micron, il aura fallu créer initialement des îlots de hauteur h (fig 2) égale à environ la largeur L de l'îlot. Sur les figures, on a représenté un cas où on accepte une valeur de z plus faible (par exemple 0,25 micron) et une profondeur de creusement d plus grande que 1/4, par exemple 0,3 micron de sorte que la hauteur h peut être sensiblement égale à la moitié de la largeur L.

On peut noter qu'il n'y a pas de phénomène de "bec d'oiseau" risquant de soulever le nitrure lors de l'oxydation épaisse sur les flancs de l'îlot car le nitrure repose directement sur le silicium de l'îlot.

La dernière étape non représentée consistera à enlever le nitrure subsistant sur le dessus et les flancs de l'îlot, après quoi on pourra réaliser les éléments de circuit intégré désirés sur les îlots.

6

Le silicium monocristallin ainsi isolé diélectriquement du substrat est de la même qualité que le silicium du substrat.

Avant la gravure des îlots 16, on peut très bien avoir procédé à des dopages variés de la surface de la tranche : par exemple on aura pu effectuer des implantations de formation de caissons ou de formation de source et de drain de transistors.

On peut réaliser des circuits bipolaires comme des circuits MOS par ce procédé.

Si on prévoit en certains endroits des îlots suffisament élargis pour que l'oxydation finale ne permette pas de combler la largeur L-2d du pied de l'îlot de silicium après la gravure isotrope de silicium de la figure 5, on pourra connecter certains éléments de circuit au substrat.

La structure réalisée permet de façon parfaitement compatible de réaliser sur une même puce de circuit intégré à la fois des éléments isolés diélectriquement du substrat et des éléments non isolés ou classiquement isolés par jonction.

Enfin, le procédé décrit est particulièrement simple : il ne comporte qu'un petit nombre d'étapes très classiques, avec un seul masque de définition des îlots.

REVENDICATIONS

1. Procédé pour former sur un circuit intégré des îlots de silicium monocristallin isolés du substrat, caractérisé en ce que :

a) on part d'une tranche (10) de semiconducteur monocristallin que l'on recouvre, éventuellement après une oxydation mince (12), d'une première couche (14) de nitrure de silicium,

b) on grave le nitrure selon un motif laissant subsister des zones de faible largeur (fig 1),

c) on creuse verticalement le silicium monocristallin en dehors des endroits protégés par le nitrure (14), de sorte qu'il subsiste des îlots (16) de silicium monocristallin dont la surface supérieure est recouverte de nitrure (fig 2),

d) on dépose une deuxième couche (18) de nitrure de silicium qui recouvre la surface de la tranche ainsi que les flancs de l'îlot et la première couche de nitrure (fig 3),

e) on effectue une gravure anisotrope verticale du nitrure jusqu'à mise à nu du silicium en dehors des îlots, le nitrure de la deuxième couche (18) subsistant alors sur les flancs des îlots et celui de la première couche (14) subsistant sur le dessus des îlots (fig 4),

f) on effectue une gravure isotrope du silicium dénudé, en dehors des îlots protégés par le nitrure, cette gravure s'étendant partiellement sous les îlots (fig 5),

g) on effectue une oxydation thermique épaisse de la tranche pendant une durée suffisante pour que se forme une couche d'oxyde de silicium (20) s'étendant complètement sous les îlots et isolant diélectriquement ceux-ci du substrat (fig 6),

h) on retire la couche de nitrure subsistant sur les îlots.

2. Procédé selon la revendication 1, caractérisé en ce que la hauteur h des îlots de silicium monocristallin après

8

l'étape c est d'au moins la moitié environ de la largeur L des flots.

3. Procédé selon la revendication 1, caractérisé en ce que la profondeur p de gravure du silicium à l'étape f est environ égale au quart de la largeur L des flots.

Fig.1

Fig.2

Fig.3

Fig.4

Fig.5

Fig.6